# Europäisches Patentamt
## European Patent Office
## Office européen des brevets

(19)

(11) Veröffentlichungsnummer: **0 089 078**
**B1**

(12) **EUROPÄISCHE PATENTSCHRIFT**

(45) Veröffentlichungstag der Patentschrift:
**14.06.89**

(51) Int. Cl.⁴: **H 03 C  3/06, H 03 H  11/48**

(21) Anmeldenummer: **83200307.3**

(22) Anmeldetag: **02.03.83**

(54) Schaltungsanordnung für einen FM-Empfänger.

(30) Priorität: **11.03.82  DE 3208758**

(43) Veröffentlichungstag der Anmeldung:
**21.09.83 Patentblatt 83/38**

(45) Bekanntmachung des Hinweises auf die Patenterteilung:
**14.06.89 Patentblatt 89/24**

(84) Benannte Vertragsstaaten:
**DE FR GB IT**

(56) Entgegenhaltungen:
**DE-A- 1 948 872**
**DE-A- 2 706 662**
**GB-A- 2 059 702**

**MICROELECTRONICS & RELIABILITY, Band 21, Nr. 2,
1981, Seiten 183-189, Pergamon Press Ltd., Oxford, GB;
D. KASPERKOVITZ et al.: "An integrated FM receiver"**

(73) Patentinhaber: **Philips Patentverwaltung GmbH,
Wendenstrasse 35 Postfach 10 51 49,
D-2000 Hamburg 1 (DE)**

(84) Benannte Vertragsstaaten: **DE**

(73) Patentinhaber: **N.V. Philips' Gloeilampenfabrieken,
Groenewoudseweg 1, NL-5621 BA Eindhoven (NL)**

(84) Benannte Vertragsstaaten: **FR GB IT**

(72) Erfinder: **Nolde, Wolfgang, Dr., Im Ginsterbusch 5,
D-2000 Hamburg 61 (DE)**
Erfinder: **Jansen, Winfried, Alter Kirchweg 85,
D-2081 Hasloh (DE)**
Erfinder: **Kasperkovitz, Wolfdietrich, Dr., Eikenlaan 4,
Waalre (NL)**

(74) Vertreter: **Hartmann, Heinrich, Dipl.-Ing. et al, Philips
Patentverwaltung GmbH
Wendenstrasse 35 Postfach 10 51 49,
D-2000 Hamburg 1 (DE)**

## Beschreibung

Die Erfindung betrifft eine Schaltungsanordnung nach dem Oberbegriff des Hauptanspruchs. Eine solche Schaltungsanordnung ist aus der DE-A-3 032 701 bekannt. Dabei wird das gesamte FM-Demodulator-Ausgangssignal – also nicht nur dessen Gleichanteil – zur Steuerung der Oszillatorfrequenz benutzt. Auch bei einer festen Abstimmung auf einen Sender ändert sich also dabei die Oszillatorfrequenz ständig entsprechend dem Niederfrequenz-Ausgangssignal, und zwar derart, daß der Frequenzhub des frequenzmodulierten Eingangssignals verringert wird. Dadurch ist es möglich, eine Zwischenfrequenz zu wählen, die in der Größe des Frequenzhubes liegt oder sogar etwas darunter. Bei UKW-Empfängern, bei denen das Eingangssignal bekanntlich einen Frequenzhub von 75 kHz aufweist, kann beispielsweise eine Zwischenfrequenz von 70 kHz gewählt werden. Dies hat den Vorteil, daß die Filterung im Zwischenfrequenzbereich durch einen RC-Tiefpaß erfolgen kann, der keinen Abgleich erfordert.

Ein Nachteil des bekannten FM-Empfängers besteht darin, daß die Amplitude des Ausgangssignals und die Übertragungs-Bandbreite stark von der Abstimmfrequenz des Oszillators abhängen, wenn die Oszillatorfrequenz vom FM-Demodulator in üblicher Weise mittels einer Kapazitätsdiode gesteuert wird.

Darüber hinaus ist es aus der DE-A-2 706 662 bekannt, in einem FM-Demodulator eine gleichspannungsgesteuerte Schwingkreiskapazität für den Oszillator vorzusehen, wobei die Gleichspannungs-Vorspannung der Schwingkreiskapazität in Abhängigkeit von der jeweils eingestellten Trägerfrequenz bestimmt wird. Dadurch soll ein konstanter Frequenzhub des modulierten Trägers im gesamten Frequenzbereich erreicht werden.

Aufgabe der Erfindung ist es, eine Schaltungsanordnung der eingangs genannten Art so auszubilden, daß die Amplitude des Ausgangssignals und die Übertragungs-Bandbreite von der Abstimmfrequenz des Oszillators praktisch unabhängig sind.

Diese Aufgabe wird erfindungsgemäß dadurch gelöst, daß der Oszillatorkreis durch eine in der Schleife enthaltene Reaktanzschaltung verstimmbar ist, deren vom Ausgangssignal des FM-Demodulators gesteuerte Reaktanz die gleiche Abhängigkeit von der Abstimmfrequenz des Oszillatorkreises aufweist wie der Quotient aus einer Induktivitäts- bzw. Kapazitätsänderung und der durch sie im Oszillatorkreis bewirkten Änderung der Oszillatorfrequenz.

Als Reaktanzschaltung wird dabei eine aktive Elemente enthaltende Schaltung bezeichnet, deren Blindleitwert proportional zu dem Signal an seinem Steuereingang steuerbar ist.

Die Erfindung beruht auf der Erkenntnis, daß die Abhängigkeit der Amplitude des Ausgangssignals und der Übertragungs-Bandbreite von der Abstimmfrequenz eine Folge der Frequenzabhängigkeit der Schleifenverstärkung ist. Wenn nun der Blindleitwert in der angegebenen Weise von der Abstimmfrequenz abhängt, ergibt sich eine von der Abstimmfrequenz unabhängige Nachstimmsteilheit (das ist der Quotient aus der Änderung der Oszillatorfrequenz und der Änderung des Momentanwertes des FM-Demodulator-Ausgangssignals). Daraus ergibt sich eine frequenzunabhängige Schleifenverstärkung bzw. eine frequenzunabhängige Amplitude des Ausgangssignals und eine frequenzunabhängige Übertragungs-Bandbreite.

Die erforderliche Frequenzabhängigkeit der Reaktanz hängt von dem Aufbau des Oszillatorkreises und insbesondere davon ab, auf welche Weise er abgestimmt wird. Wenn der Oszillatorkreis z.B. durch eine Induktivität abgestimmt wird und zur Änderung der Oszillatorfrequenz in Abhängigkeit vom Demodulator-Ausgangssignal eine kapazitive Nach- bzw. Verstimmung benutzt wird, muß die durch die Reaktanzschaltung erzeugte Kapazität der Abstimmfrequenz umgekehrt proportional sein. Bei Oszillatorkreisen hingegen, die durch eine Kapazität abgestimmt werden, ist gemäß einer Weiterbildung der Erfindung vorgesehen, daß die Reaktanzschaltung so ausgebildet ist, daß an ihrem Ausgang eine Kapazität wirksam ist, die dem Kehrwert der dritten Potenz der Abstimmfrequenz proportional ist. Der Wirkleitwert der Reaktanzschaltung sollte möglichst klein und von der Oszillatorfrequenz unabhängig sein.

Eine kapazitiv wirksame Reaktanzschaltung, die eine derartige Frequenzabhängigkeit aufweist, ist dadurch gekennzeichnet, daß die Reaktanzschaltung ein Tief- oder Bandpaßnetzwerk höherer Ordnung enthält, dem das Oszillatorsignal zugeführt wird, daß das gefilterte Signal in einer Multiplizierstufe mit dem FM-Demodulator-Ausgangssignal multipliziert wird, daß das Produktsignal als eingeprägter Strom in den Oszillatorkreis zurückgespeist wird, so daß sich parallel zum Oszillatorkreis ein kapazitiver Blindleitwert ergibt, und daß die obere Grenzfrequenz des Tief- oder Bandpaßnetzwerkes so gewählt ist, daß das Maximum des Produktes des Blindleitwertes und des Quadrates der Frequenz im Abstimmfrequenzbereich oder in dessen Nähe liegt. In einer Vorzugsausführung enthält die Reaktanzschaltung ein Tiefpaßnetzwerk, das zwei Tiefpässe umfaßt. Die Tiefpässe können voneinander entkoppelt sein, d.h., daß zwischen den Tiefpaßfiltern Schaltelemente derart vorgesehen sind, daß die Übertragungsfunktion jedes der beiden Tiefpässe durch den anderen Tiefpaß nicht beeinflußt wird, so daß die Gesamt-Übertragungsfunktion dem Produkt der Übertragungsfunktionen der einzelnen Tiefpässe entspricht.

Eine derartige Reaktanzschaltung ist mit Vorteil nicht nur bei Schaltungen für Empfänger der eingangs genannten Art anwendbar, sondern auch bei anderen Empfängern zur automatischen Scharfabstimmung.

Die Kapazität, die diese Reaktanzschaltung erzeugt, ist dem Kehrwert der dritten Potenz der Abstimmfrequenz nicht exakt proportional, jedoch sind die Abweichungen von dem exakten Wert gering, wenn die Grenzfrequenzen der Tiefpässe so gewählt sind, daß das Maximum des Produktes aus dem Blindleitwert und der Frequenz in den Abstimmfrequenzbereich des Oszillatorkreises fällt; liegt das Maximum beispielsweise bei etwa 98 MHz, dann ergeben sich für den gesamten UKW-Bereich (88 bis 108 MHz) nur Abweichungen von einigen Promille. Wenn die Abstimmfrequenzen sehr hoch liegen z. B. im UKW-Bereich, können die Tiefpässe durch RC-Glieder mit derart kleiner Zeitkonstante realisiert werden, daß sie in integrierter Schaltungstechnik herstellbar sind.

Die Erfindung wird nachstehend anhand der Zeichnung näher erläutert. Es zeigen

Fig. 1 ein Blockschaltbild eines erfindungsgemäßen Empfängers,

Fig. 2 ein Blockschaltbild einer erfindungsgemäßen Reaktanzschaltung, und

Fig. 3 den konkreten Aufbau der Reaktanzschaltung.

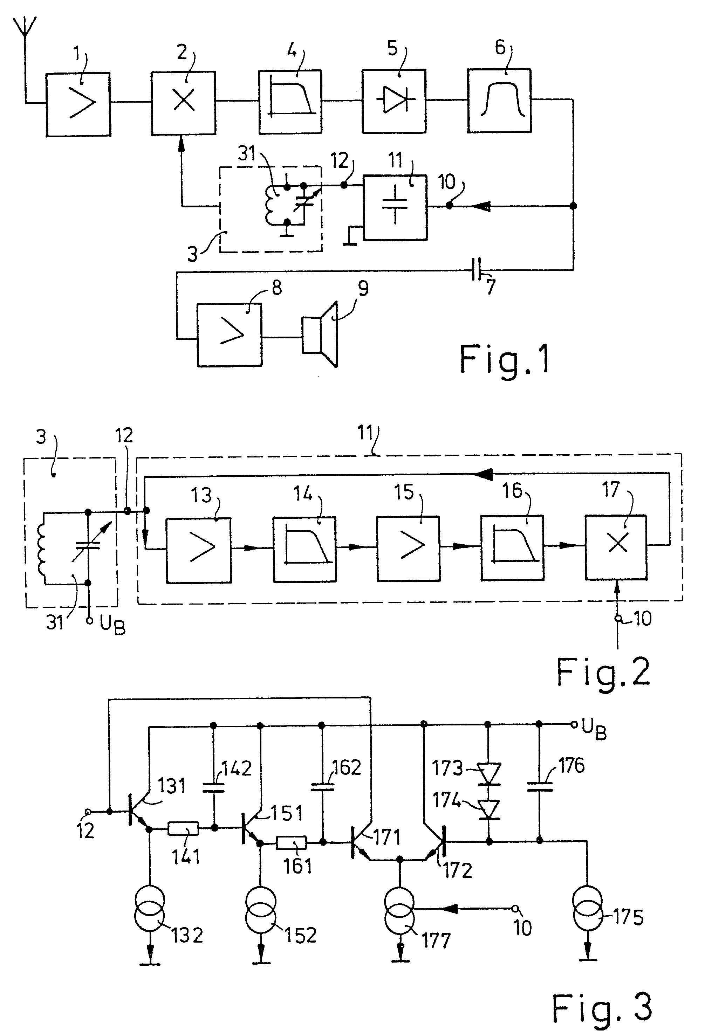

Das in Fig. 1 dargestellte Blockschaltbild eines UKW-Empfängers zeigt eine Mischstufe 2, die das von einem das Antennensignal verstärkenden Eingangsverstärker 1 gelieferte Eingangssignal mit dem von einem Oszillator 3 gelieferten Oszillatorsignal mischt. Die Differenz zwischen der Frequenz des Eingangssignals und des Oszillatorsignals ist relativ gering – 70 kHz, so daß die erforderliche Selektion im ZF-Bereich mit Hilfe eines einfach aufgebauten Tiefpasses 4 realisiert werden kann. Dem Tiefpaß 4 ist ein FM-Demodulator 5 nachgeschaltet, der so ausgebildet ist, daß die Amplitude seines Ausgangssignals der Frequenzabweichung seines Eingangssignals von der Zwischenfrequenz (70 kHz) proportional ist. Das Ausgangssignal des FM-Demodulators 5 wird über ein geeignetes Filter, das der Stabilisierung dient und das bei Mono-Empfängern ein einfacher Tiefpaß sein kann, dessen Grenzfrequenz niedriger liegt als die des Tiefpasses 4, das jedoch so bemessen ist, daß das Niederfrequenz-Ausgangssignal des Demodulators 5 keine frequenzabhängige Dämpfung erfährt, und über einen Trennkondensator 7, der den Gleichanteil des Demodulator-Ausgangssignals entfernt, einem Verstärker 8 mit einem nicht näher dargestellten Deemphasisglied zugeführt, der einen Lautsprecher 9 speist.

Das Ausgangssignal des Filters 6, d. h. seine Niederfrequenz und seine Gleichspannungs- bzw. Gleichstrom-Komponenten werden zugleich dem Steuereingang 10 einer Reaktanzschaltung 11 zugeführt. Diese Reaktanzschaltung wirkt an ihrem Ausgang 12 als zum Signal an ihrem Steuereingang 10 proportionale Kapazität. Diese Kapazität liegt parallel zu dem als Parallel-Resonanzkreis ausgebildeten, durch einen Kondensator abstimmbaren Oszillatorkreis 31 im Oszillator 3, wobei die durch die Reaktanzänderung hervorgerufene Verstimmung des Oszillatorkreises 31 vernachlässigbar klein im Vergleich zu dessen Abstimmfrequenz bleibt. Die durch die Reaktanzschaltung 11 hervorgerufene Änderung der Oszillatorfrequenz erfolgt derart, daß die Differenz zwischen den Frequenzen des Eingangssignals und des Oszillatorsignals verringert wird. Je nach Größe der (negativen) Schleifenverstärkung in der durch die Komponenten 2...6, 11 gebildeten Schleife wird dadurch der Frequenzhub des Eingangssignals mehr oder weniger komprimiert. Ein praktischer Wert für diese Kompression liegt bei etwa 5, so daß sich hinter dem Mischer bei UKW nur noch ein Frequenzhub von 15 kHz ergibt, so daß die Zwischenfrequenz niedriger sein darf als der Frequenzhub des Eingangssignals, ohne daß dadurch die Übertragungsqualität negativ beeinflußt wird.

Ein Problem bei einer derartigen Schaltung besteht darin, daß die durch eine bestimmte Kapazitätsänderung der Reaktanzschaltung 11 hervorgerufene Veränderung der Abstimmfrequenz von der Größe dieser Abstimmfrequenz abhängt, und zwar mit der dritten Potenz. Die auf die Kapazitätsänderung bezogene Frequenzänderung ist also an der oberen Grenze (108 MHz) des UKW-Bereiches fast doppelt so groß wie an der unteren Grenze (88 MHz). Infolgedessen ändert sich auch die Schleifenverstärkung mit der dritten Potenz der Abstimmfrequenz und damit auch die Amplitude des Niederfrequenz-Ausgangssignals sowie die NF-Übertragungs-Bandbreite. Wenn nun die Reaktanzschaltung 11 so ausgebildet wird, daß sich ihre Kapazität mit dem Kehrwert der dritten Potenz der Abstimmfrequenz ändert sowie proportional zur Amplitude des Signals am Steuereingang 10, ergibt sich eine konstante Schleifenverstärkung, und die geschilderten Nachteile einer frequenzabhängigen Schleifenverstärkung entfallen.

In Fig. 2 ist das Blockschaltbild einer Reaktanzschaltung mit einer solchen Frequenzabhängigkeit dargestellt. Die Schaltung enthält einen ersten Verstärker 13 mit einem hochohmigen Eingang, der den Oszillatorkreis 31 praktisch nicht belastet. Ihm folgt ein Tiefpaß 14 mit der Übertragungsfunktion $1/(1 + jwT1)$, wobei w die Frequenz des Signals am Punkt 12 und T1 eine von der Dimensionierung des Tiefpasses abhängige Zeitkonstante ist. Diesem Tiefpaß folgt ein zweiter Verstärker 15, der den Tiefpaß 14 von einem mit dem Ausgang des Verstärkers 15 verbundenen weiteren Tiefpaß 16 mit der Übertragungsfunktion $1/(1 + jwT2)$ entkoppelt, wobei T2 eine von der Bemessung des Tiefpasses 16 abhängige Zeitkonstante ist, so daß die Übertragungsfunktion der beiden Tiefpässe durch den Eingang bzw. den Ausgang des jeweils anderen Tiefpasses nicht beeinflußt wird. Das Ausgangssignal des Tiefpasses 16 wird dem einen Eingang einer Multiplizierstufe 17 zugeführt, deren anderer Eingang 10 den Steuereingang der Reaktanzschaltung bildet und an dem das Ausgangssignal des FM-Demodulators 5 anliegt. Am Ausgang der Multiplizierschaltung 17 ergibt sich daher ein Signal, das u. a. dem Produkt der Übertragungsfunktion der Tiefpässe 14 und 16 sowie der Amplitude des Signals am Steuereingang 10 proportional ist.

Die Multiplizierschaltung 17 hat einen hochohmigen Ausgang und liefert daher einen eingeprägten Strom, der der Klemme 12 bzw. dem Eingang des Entkoppelverstärkers 13 zugeführt wird. Der sich dabei ergebende Blindleitwert ist dem Imaginärteil des Produktes der Übertragungsfunktion der beiden Tiefpässe proportional und kapazitiv, wenn die Elemente 13, 15, 17 insgesamt eine Phasendrehung von 180 Grad hervorrufen.

Dieses Produkt bzw. dieser Blindleitwert entspricht jedoch nur in einem begrenzten Frequenzbereich einer Kapazität, die dem Kehrwert der dritten Potenz der Frequenz proportional ist. Der Bereich, in dem diese Voraussetzung erfüllt ist, zeichnet sich dadurch aus, daß das Produkt des Blindleitwertes mit dem Quadrat der Abstimmfrequenz konstant ist, was im Bereich des Maximums dieses Produktes der Fall ist. Da das Maximum in der Regel flach ist, ist die Bedingung auch in einem größeren Frequenzbereich erfüllt.

Wenn die beiden Tiefpässe 14 und 16 beispielsweise den gleichen Frequenzgang haben, dann liegt das Maximum des letztgenannten Produktes etwa um den Faktor $\sqrt{3}$ höher als die 3 dB Grenzfrequenz der beiden Tiefpässe. Wenn das Maximum im Abstimmfrequenzbereich des Oszillators 3 liegt, stellt die Reaktanzschaltung näherungsweise eine Kapazität dar, die der dritten Potenz der Abstimmfrequenz umgekehrt proportional ist. Die Abweichungen sind um so geringer, je kleiner der Abstimmbereich im Vergleich zur Mittenfrequenz dieses Bereiches ist. Bei UKW z.B. ergibt sich, daß die Abweichung vom Idealwert im ganzen Abstimmbereich kleiner als 0,5% ist, wenn die 3 dB-Grenzfrequenz etwa bei 56,3 MHz liegt.

Die Zeitkonstanten T1 und T2 der beiden Tiefpässe müssen jedoch nicht einander gleich sein. Man erhält z.B. ähnlich gute Ergebnisse, wenn die 3 dB-Grenzfrequenzen der beiden Tiefpässe bzw. der Kehrwert der Zeitkonstanten sich wie 3/4:4/3 verhalten und die höhere Grenzfrequenz etwa 26% unterhalb des Abstimmbereiches liegt, oder wenn die beiden Grenzfrequenzen sich wie 1:4 verhalten und die Abstimmfrequenz bzw. die Mitte des Abstimmfrequenzbereiches 10% oberhalb der höheren 3 dB-Grenzfrequenz liegt. Je stärker sich die beiden Grenzfrequenzen voneinander unterscheiden, desto geringer muß der Abstand der höheren der beiden Grenzfrequenzen von der über ihr liegenden Mittenfrequenz des Abstimmbereiches werden.

Ein bevorzugtes Ausführungsbeispiel der in Fig. 2 im Blockschaltbild dargestellten Reaktanzschaltung ist in Fig. 3 dargestellt. Die Entkoppelstufe 13 wird dabei durch einen Emitterfolger mit dem npn-Transistor 131 und der Emitter-Stromquelle 132 gebildet. Die Basis des Transistors 131 ist über die Klemme 12 und die Induktivität des Oszillatorkreises 31 mit der gleichen Spannung $U_B$ verbunden, an die auch der Kollektor dieses Transistors angeschlossen ist. An den Emitter ist ein Widerstand 141 von 750 Ohm angeschlossen, der zusammen mit einem Kondensator 142 von 1,8 pF den ersten Tiefpaß 14 bildet. Die darauf folgende Entkoppelstufe 15 besteht wiederum aus einem Emitterfolger mit dem Transistor 151 und der Stromquelle 152 (die beiden Stromquellen 132 und 152 liefern einen eingeprägten Gleichstrom von 100 µA), wobei an den Emitter des Transistors 151 wiederum ein Widerstand 161 von 750 Ohm angeschlossen ist, der zusammen mit einem Kondensator 162, dessen anderes Ende an die Speisespannung $U_B$ angeschlossen ist, den Tiefpaß 16 bildet. Der Verbindungspunkt des Widerstandes 161 und des Kondensators 162, d.h. der Ausgang dieses Tiefpasses, ist mit der Basis eines npn-Transistors 171 verbunden, dessen Emitter mit dem Emitter eines Transistors 172 verbunden ist. Die Basis des Transistors 172 ist über zwei in Serie und in Durchlaßrichtung geschaltete, vom Gleichstrom einer Gleichstromquelle 175 (100 µA) durchflossenen Dioden mit der positiven Speisespannung verbunden, so daß die Basisgleichspannungen der Transistoren 171 und 172 einander ungefähr gleich sind. Ein Kondensator 176 bildet für Signale mit Frequenzen im UKW-Bereich annähernd einen Kurzschluß der Diodenstrecke. In die gemeinsame Emitterzuleitung der Transistoren 171, 172 ist eine steuerbare Stromquelle 177 aufgenommen, die einen Strom liefert, der dem Momentanwert des Signals am Steuereingang 10 proportional ist. Dieser Strom teilt sich annähernd zur Hälfte auf die beiden Transistoren 171 und 172 auf, wobei der Strom über den Transistor 172 wieder in die Batterie fließt, während der Strom des Transistors 171 zur Basis des Transistors 131 bzw. zur Klemme 12 zurückfließt.

Die anhand von Fig. 3 beschriebene Reaktanzschaltung ist für UKW-Empfänger geeignet. Zwar liegt die 3 dB-Grenzfrequenz (der Kehrwert des Produktes aus dem 750 Ohm-Widerstand und dem 1,8 pF-Kondensator) wesentlich höher als in Verbindung mit Fig. 2 angegeben. Berücksichtigt man jedoch, daß parallel zu den Kondensatoren 142 und 162 die Eingangskapazitäten der Transistoren 151 und 171 wirksam sind, dann wird klar, daß sich dabei die geforderten Übertragungsfunktionen der Tiefpässe ergeben können. Da die Kapazitäten der Kondensatoren 142, 162 und 176 alle sehr klein sind, kann die Reaktanzschaltung insgesamt leicht in integrierter Schaltungstechnik hergestellt werden.

Die in Fig. 2 bzw. Fig. 3 dargestellte Reaktanzschaltung hat einen negativen Wirkleitwert, wenn die Phasendrehung der Bauelemente 13, 15 und 17 180 Grad beträgt, wodurch der Oszillator 3 zusätzlich entdämpft wird. Er muß so bemessen werden, daß er trotzdem sicher schwingt.

Der Wirkleitwert der Reaktanzschaltung steigt proportional zum Strom der Stromquelle, d.h. proportional zum Ausgangssignal des FM-Demodulators, und entsprechend ändert sich auch die Entdämpfung des Oszillators. Das kann u.U. zu einer unerwünschten Amplitudenmodulation des Oszillatorsignals und des ZF-Signals führen. Dies läßt sich vermeiden, wenn der Oszillator in Abhängigkeit vom NF-Ausgangssignal so gesteuert wird, daß die Abhängigkeit der Oszillatoramplitude vom NF-Ausgangssignal wenigstens näherungsweise kompensiert wird.

Daneben hängt der Wirkleitwert auch noch von der Oszillatorfrequenz ab, was aber zumindest bei Anwendung im UKW-Bereich nicht sehr stört.

Statt mit dem Kollektor des Transistors 171 kann die Klemme 12 auch mit dem Kollektor des Transistors 172 verbunden sein. Der Scheinleitwert zwischen der Klemme 12 und Erde kehrt dann sein Vorzeichen um. Anstelle einer (positiven) Kapazität ergibt sich dann eine negative Kapazität – d.h. die Kapazität des Oszillatorkreises wird durch die parallelgeschaltete Reaktanzschaltung verringert–, jedoch hat auch diese negative Kapazität die erforderliche Frequenzabhängigkeit. Der Wirkleitwert der Reaktanzschaltung ist dann positiv, d.h. der Oszillator wird dadurch entdämpft, was bei der Dimensionierung berücksichtigt werden muß. Die Abhängigkeit dieses Wirkleitwertes von dem Signal an dem Steuereingang 10 kann aber in entsprechender Weise kompensiert werden, wie vorstehend beschrieben.

Die Reaktanzschaltung arbeitet auch dann zufriedenstellend, wenn die Entkoppelstufe 15 bzw. 151, 152 entfällt, so daß die Tiefpässe 14 und 16 unmittelbar in Kaskade geschaltet sind. Die gewünschte Frequenzabhängigkeit des Blindleitwertes ergibt sich aber bei einer anderen Bemessung der Tiefpässe. Sind beispielsweise die Tiefpässe identisch, dann muß ihre 3 dB-Grenzfrequenz, d.h. der Kehrwert ihrer Zeitkonstante, etwa bei 36,8% der Mittenfrequenz des Abstimmfrequenzbereiches des Oszillators liegen. Anstelle der beiden Tiefpässe 14 und 16 können Netzwerke benutzt werden, deren Blindleitwert im Abstimmbereich sich wenigstens annähernd proportional zum Quadrat der Frequenz ändert. Der Frequenzbereich, in dem dies der Fall ist, ist am größten in der Nähe des Maximums des Produktes des Blindleitwertes und des Quadrates der Frequenz, d.h. dieses Maximum soll im Abstimmbereich oder in dessen Nähe liegen. Solche Netzwerke können zweiter oder höherer Ordnung sein und haben eine Tief- oder Bandpaßcharakteristik mit einer gewissen, das genannte Frequenzgebiet bestimmenden oberen Grenzfrequenz.

**Patentansprüche**

1. Schaltungsanordnung für einen FM-Empfänger mit einer Schleife, deren Schleifenverstärkung zumindest für die niedrigen Frequenzen des demodulierten Signals negativ ist und die einen FM-Demodulator (5), einen vom Ausgangssignal des FM-Demodulators (5) in der Frequenz durch eine Kapazitäts- oder Induktivitätsänderung gesteuerten, abstimmbaren Oszillatorkreis (31) und eine Mischstufe (2) enthält, die das Oszillatorsignal mit einem Eingangssignal mischt und deren Ausgang mit dem Eingang des FM-Demodulators (5) gekoppelt ist, dadurch gekennzeichnet, daß der Oszillatorkreis (31) durch eine in der Schleife enthaltene Reaktanzschaltung (11) verstimmbar ist, deren vom Ausgangssignal des FM-Demodulators (5) gesteuerte Reaktanz die gleiche Abhängigkeit von der Abstimmfrequenz des Oszillatorkreises (31) aufweist wie der Quotient aus einer Induktivitäts- bzw. Kapazitätsänderung und der durch sie im Oszillatorkreis bewirkten Änderung der Oszillatorfrequenz.

2. Schaltungsanordnung nach Anspruch 1, wobei der Oszillatorkreis durch eine veränderbare Kapazität abstimmbar ist, dadurch gekennzeichnet, daß die Reaktanzschaltung (11) so ausgebildet ist, daß an ihrem Ausgang eine Kapazität wirksam ist, die dem Kehrwert der dritten Potenz der Abstimmfrequenz proportional ist.

3. Schaltungsanordnung für einen Empfänger mit einer durch ein FM-Demodulatorausgangssignal gesteuerten, kapazitiv wirksamen Reaktanzschaltung zur Beeinflussung der Frequenz eines Oszillatorkreises, insbesondere nach Anspruch 2, dadurch gekennzeichnet, daß die Reaktanzschaltung ein Tief- oder Bandpaßnetzwerk höherer Ordnung enthält, dem das Oszillatorsignal zugeführt wird, daß das gefilterte Signal in einer Multiplizierstufe (17) mit dem FM-Demodulator-Ausgangssignal multipliziert wird, daß das Produktsignal als eingeprägter Strom in den Oszillatorkreis (31) zurückgespeist wird, so daß sich parallel zum Oszillatorkreis ein kapazitiver Blindleitwert ergibt, und daß die obere Grenzfrequenz des Tief- oder Bandpaßnetzwerkes so gewählt ist, daß das Maximum des Produktes des Blindleitwertes der Reaktanzschaltung und des Quadrates der Frequenz im Abstimmfrequenzbereich oder in dessen Nähe liegt.

4. Schaltungsanordnung nach Anspruch 3, dadurch gekennzeichnet, daß die Reaktanzschaltung ein Tiefpaßnetzwerk enthält, das zwei Tiefpässe (14, 16) umfaßt, zwischen die eine Entkoppelstufe (15) geschaltet ist.

5. Schaltungsanordnung nach Anspruch 3, dadurch gekennzeichnet, daß die Reaktanzschaltung ein Tiefpaßnetzwerk enthält, das aus zwei unmittelbar in Kaskade geschalteten Tiefpässen (14, 16) besteht.

6. Schaltungsanordnung nach Anspruch 4, dadurch gekennzeichnet, daß die Grenzfrequenzen der beiden Tiefpässe einander gleich sind und bei etwa 58% der Mittenfrequenz des Abstimmfrequenzbereiches des Oszillatorkreises (31) liegt.

7. Schaltungsanordnung nach Anspruch 4, dadurch gekennzeichnet, daß die Grenzfrequenz des einen Tiefpasses etwa viermal so groß ist wie die des anderen und etwa 10% niedriger als die Mittenfrequenz des Abstimmbereiches des Oszillatorkreises.

8. Schaltungsanordnung nach Anspruch 4, dadurch gekennzeichnet, daß die Grenzfrequenz des einen Tiefpasses etwa um 78% größer als die des anderen Tiefpasses und um etwa 26% kleiner als die Mittenfrequenz des Abstimmbereiches des Oszillatorkreises ist.

9. Schaltungsanordnung nach Anspruch 5, dadurch gekennzeichnet, daß die beiden Tiefpässe einander gleich sind und daß ihre Grenzfrequenz jeweils bei etwa 36,8% der Mittenfrequenz des Abstimmfrequenzbereiches des Oszillatorkreises (31) liegt.

10. Schaltungsanordnung nach einem der Ansprüche 3 bis 9, dadurch gekennzeichnet, daß die Multiplizierschaltung (17) zwei Transistoren (171, 172) enthält, in deren gemeinsame Emitterzuleitung eine von dem FM-Demodulator-Ausgangssignal gesteuerte Stromquelle (177) geschaltet ist, deren Strom linear von dem FM-Demodulator-Ausgangssignal abhängt, und daß das gefilterte Signal der Basis eines der Transistoren (171) zugeführt wird und der Kollektorstrom eines der Transistoren (171) in den Oszillatorkreis (31) eingespeist wird.

11. Schaltungsanordnung nach Anspruch 4, dadurch gekennzeichnet, daß die Reaktanzschaltung einen ersten Emitterfolger (131) enthält, dessen Ausgang an einen RC-Tiefpaß (14) mit einem Widerstand (141) im Längszweig und einem Kondensator (142) im Querzweig angeschlossen ist, der dem Eingang eines zweiten Emitterfolgers (151) wechselstrommäßig parallelgeschaltet ist, an dessen Ausgang ein weiterer Tiefpaß angeschlossen ist mit einem Widerstand (161) im Längszweig und einem Kondensator (162) im Querzweig, und daß der Ausgang des weiteren Tiefpasses (161, 162) mit einem Eingang der Multiplizierstufe verbunden ist.

## Claims

1. A circuit arrangement for an FM-receiver having a loop whose loop gain is negative at least for the lower frequencies of the demodulated signal and comprising an FM-demodulator (5), an oscillator circuit (31) whose frequency is controlled by the output signal of the FM-demodulator (5) and which is tunable by means of a capacitance or inductance change, and a mixing stage (2), which mixes the oscillator signal with an input signal and its output being coupled to the input of the FM-demodulator (5), characterized in that the oscillator circuit (31) can be detuned by a reactance circuit (11) comprised in the loop whose reactance is controlled by the output signal of the FM-demodulator (5) has the same dependence on the tuning frequency of the oscillator circuit (31) as the quotient of an inductance or capacitance change, respectively and the change of the oscillator frequency caused thereby in the oscillator circuit.

2. A circuit arrangement as claimed in Claim 1, in which the oscillator circuit is tunable in accordance with a variable capacitance, characterized in that the reactance circuit (11) is of such a construction that a capacitance is active at its output, which capacitance is proportional to the inverse value of the third power of the tuning frequency.

3. A circuit arrangement for a receiver comprising a capacitively active reactance circuit controlled by an FM-demodulator output signal, for influencing the frequency of an oscillator circuit, more specifically as claimed in Claim 2, characterized in that the reactance circuit comprises a higher-order low-pass or band-pass network to which the oscillator signal is applied, in that the filtered signal is multiplied in a multiplying stage (17) by the FM-demodulator output signal, in that the product signal is fed back as an impressed current to the oscillator circuit (31) so that a capacitive susceptance is produced in parallel with the oscillator circuit and in that the upper cutoff frequency of the low-pass or band-pass network is chosen such that the maximum of the product of the susceptance of the reactance circuit and the square of the frequency is located in the tuning frequency range or in the vicinity thereof.

4. A circuit arrangement as claimed in Claim 3, characterized in that the reactance circuit comprises a low-pass network which includes two low-pass filters (14, 16) between which a decoupling stage (15) is arranged.

5. A circuit arrangement as claimed in Claim 3, characterized in that the reactance circuit comprises a low-pass network which includes two low-pass filters (14, 16) which are directly arranged in cascade.

6. A circuit arrangement as claimed in Claim 4, characterized in that the cutoff frequencies of the two low-pass filters are equal to each other and are located at approximately 58% of the centre frequency of the tuning frequency range of the oscillator circuit (31).

7. A circuit arrangement as claimed in Claim 4, characterized in that the cutoff frequency of one low-pass filter is approximately four times larger than that of the other low-pass filter and approximately 10% below the centre frequency of one tuning range of the oscillator circuit.

8. A circuit arrangement as claimed in Claim 4, characterized in that the cutoff frequency of one low-pass filter is approximately 78% larger than that of the other low-pass filter and approximately 26% lower than the centre frequency of the tuning range of the oscillator circuit.

9. A circuit arrangement as claimed in Claim 5, characterized in that the two low-pass filters are identical and that their cutoff frequencies are each located at approximately 36.8% of the centre frequency of the tuning frequency range of the oscillator circuit (31).

10. A circuit arrangement as claimed in any of the Claims 3 to 9, characterized in that the multiplying circuit (17) comprises two transistors (171, 172) whose common emitter lead includes a current source (177) which is controlled by the FM-demodulator output signal and whose current is linearly dependent on the FM-demodulator output signal, and in that the filtered signal is applied to the base of one of the transistors (171) and in that the collector current of one of the transistors (171) as applied to the oscillator circuit (31).

11. A circuit arrangement as claimed in Claim 4, characterized in that the reactance circuit comprises a first emitter-follower (131) whose output is connected to an RC-low-pass filter (14) which has a resistor (141) in the series branch and a capacitor (142) in the parallel branch, which is arranged in parallel for alternating current relative to the input of a second emitter follower (151) to the input of which a further low-pass filter is connected which has a resistor (161) in the series branch and a capacitor (162) in the parallel branch and in that the output of the further low-pass filter (161, 162) is connected to an input of the multiplying stage.

## Revendications

1. Montage de circuit pour un récepteur FM comportant une boucle dont l'amplification de boucle est négative au moins pour les fréquences inférieures du signal démodulé et qui contient un démodulateur FM (5), un circuit d'oscillateur (31) pouvant être accordé, piloté en fréquence par le signal de sortie du démodulateur FM (5) par une variation de capacité ou d'inductance et un étage mélangeur (2) qui mélange le signal d'oscillateur avec un signal d'entrée et dont la sortie est couplée à l'entrée du démodulateur FM (5), caractérisé en ce que le réglage du circuit d'oscillateur (31) peut être modifié par un circuit à réactance (11) contenu dans la boucle dont la réactance pilotée par le signal de sortie du démodulateur FM (5) présente la même dépendance de la fréquence d'accord du circuit d'oscillateur (31) que le quotient d'une variation d'inductance ou de capacité et de la variation de la fréquence d'oscillateur qu'elle provoque dans le circuit d'oscillateur.

2. Montage de circuit suivant la revendication 1, dans lequel le circuit d'oscillateur peut être accordé par une capacité variable, caractérisé en ce que le circuit à réactance (11) est conçu d'une manière telle qu'à sa sortie opère une capacité qui est proportionnelle à la réciproque de la troisième puissance de la fréquence d'accord.

3. Montage de circuit pour un récepteur comportant un circuit à réactance à action capacitive commandé par un signal de sortie de démodulateur FM en vue d'influencer la fréquence d'un circuit d'oscillateur, en particulier suivant la revendication 2, caractérisé en ce que ce circuit à réactance contient un réseau passe-bas ou passe-bande d'ordre supérieur auquel est amené le signal d'oscillateur, que le signal filtré est multiplié par le signal de sortie du démodulateur FM dans un étage multiplicateur (17), que le signal de produit est réintroduit dans le circuit d'oscillateur (31) en tant que flux injecté pour donner une susceptance capacitive parallèle au circuit d'oscillateur et que la fréquence de coupure supérieure du réseau passe-bas ou passe-bande est choisie telle que le maximum du produit de la susceptance du circuit à réactance et du carré de la fréquence tombe dans le domaine de la fréquence d'accord ou à proximité de celui-ci.

4. Montage de circuit suivant la revendication 3, caractérisé en ce que le circuit à réactance contient un réseau passe-bas qui comporte deux éléments passe-bas (14, 16) entre lesquels est connecté un étage découpleur (15).

5. Montage de circuit suivant la revendication 3, caractérisé en ce que le circuit à réactance contient un réseau passe-bas qui est formé de deux éléments passe-bas (14, 16) connectés immédiatement en cascade.

6. Montage de circuit suivant la revendication 4, caractérisé en ce que les fréquences de coupure des deux éléments passe-bas sont identiques et se situent à environ 58% de la fréquence médiane du domaine de la fréquence d'accord du circuit d'oscillateur (31).

7. Montage de circuit suivant la revendication 4, caractérisé en ce que la fréquence de coupure de l'un des éléments passe-bas vaut à peu près quatre fois celle de l'autre et est inférieure d'environ 10% à la fréquence médiane du domaine d'accord du circuit d'oscillateur.

8. Montage de circuit suivant la revendication 4, caractérisé en ce que la fréquence de coupure de l'un des éléments passe-bas est supérieure d'environ 78% à celle de l'autre et est inférieure d'environ 26% à la fréquence médiane du domaine d'accord du circuit d'oscillateur.

9. Montage de circuit suivant la revendication 5, caractérisé en ce que les deux éléments passe-bas sont identiques et que leur fréquence de coupure se situe chaque fois à peu près à 36,8% de la fréquence médiane du domaine de fréquence d'accord du circuit d'oscillateur (31).

10. Montage de circuit suivant l'une quelconque des revendications 3 à 9, caractérisé en ce que le circuit multiplicateur (17) contient deux transistors (171, 172) dans le conducteur d'émetteur commun desquels est connectée une source de courant (177) pilotée par le signal de sortie du démodulateur FM, dont le courant dépend de manière linéaire du signal de sortie du démodulateur FM, et que le signal filtré est amené à la base de l'un des transistors (171) tandis que le courant de collecteur de l'un des transistors (171) est injecté dans le circuit d'oscillateur (31).

11. Montage de circuit suivant la revendication 4, caractérisé en ce que le circuit à réactance contient un premier émetteur-suiveur (131) dont la sortie est connectée à un élément passe-bas RC (14) comportant une résistance (141) dans la branche longitudinale et un condensateur (142) dans la branche transversale, qui est monté en parallèle en courant alternatif à l'entrée d'un deuxième émetteur-suiveur (151) à la sortie duquel est connecté un autre élément passe-bas comportant une résistance (161) dans la branche longitudinale et un condensateur (162) dans la branche transversale, et la sortie de l'autre élément passe-bas (161, 162) est connectée à une entrée de l'étage multiplicateur.

Fig.1

Fig.2

Fig.3